# EUROPEAN PATENT APPLICATION

(11) **EP 1 365 507 A1**
(43) Date of publication of application: **26.11.2003**
(21) Application number: 02253619.7
(22) Date of filing: 22.05.2002
(51) Int. Cl.: H03H 7/01

(54) **Universal tuning and matching device**

(71) Applicant: LUCENT TECHNOLOGIES INC., Murray Hill, New Jersey 07974-0636 (US)
(72) Inventor: Eckl, Wolfgang F., 91080 Spardof (DE); Fischer, Georg, 90419 Nürnberg (DE); Kaminski, Gerhard, 90765 Fürth (DE)
(74) Representative: Sarup, David Alexander

(57) **Abstract**

The invention relates to an universal tuning and matching device.

An object of the invention is to provide a new and improved approach for providing an increased reconfiguration flexibility for high frequency or radio frequency signal transmission systems and/or applications by simultaneously reducing undesirable parasitic influences.

The invention proposes a device for high frequency tuning and/or matching incorporating within one IC-package at least two capacitors (C₁, C₂, C₃) and two inductors (L₁, L₂, L₃), at least one signal path with at least one input and one output port (rf-port1, rf-port2, rf-prot3) and controllable switching means (1_{C1}, 1_{C2}, 1_{C3}, 1_{L1}, 1_{L2}, 1_{L3}) for individually connecting and disconnecting at least one of the capacitors (C₁, C₂, C₃) and/or at least of the inductors (L₁, L₂, L₃) into the signal path or from the signal path.

## Description

The invention relates to an universal tuning and matching device.

In particular with regard to mobile communication systems, such as based on a GSM (Global System for Mobile communications), UMTS (Universal Mobile Telecommunication Systems), WCDMA (Wideband Code Division Multiple Access) and/or CDMA 2000 standard there is a permanently increasing need to design re-configurable multiband and/or multistandard mobile communication systems. This for example, is based on the fact that more and more frequency bands are opened up and being licensed for mobile communication.

However, until today for every new frequency band an individual radio has to be designed that forces an infrastructure and terminal vendor to a great variety of products, in particular in terms of base stations and/or user terminals, such as handsets adapted to be used within these communication systems.

As a consequence, for ensuring re-configurability in terms of frequency band and system standards there is a need for new receiving and/or transmitting architectures comprising improved flexible circuits for optimization, tuning and/or matching purposes.

Moreover, even with regard to other high frequency receiving/transmitting-systems for data transmission there is an increased need for receiver and/or transmitter chains, which provide a flexibility in use by a re-configurable functionality and some tuning and/or matching facilities for optimization.

A most common solution for providing a certain amount of reconfiguration flexibility, for example of a receiver/transmitter chain within a mobile communication system is, to implement a lot of high-frequency or radio-frequency switches and/or high-frequency or radio-frequency tuning devices, such as varactors and/or tunable inductors. In addition certain parts of a receiver/transmitter device may be activated and/or deactivated via switching a respective supply or control voltage on or off.

However, by implementing on a printed circuit board (PCB) or something similar a plurality of discrete devices, in particular radio frequency-switches, tunable inductors and/or varactors devices to achieve a flexible re-configurable system the following problems usually will be accounted.

By using a discrete switch-device additional high frequency parasitic capacitors and inductors are introduced in particular due to the oscillating circuits incorporated thereby. In addition, discrete radio-frequency switch-devices usually have some not defined coupling between the radio frequency-path and the signal path for controlling the switching. Furthermore, discrete varactors usually also have parasitic components and are using the same port for the control-voltage and for the radio-frequency path. Moreover, for an automatic tuning operation, discrete tunable inductors are not available on the market and discrete inductors itself usually have poor tolerances, a poor Q-factor and are expensive.

Finally, the creation of the layout on a printed circuit board with the plurality of discrete devices is extremely difficult and, in particular if a very complex distributed layout is necessary, often impossible. Moreover, a distributed layout usually needs a high amount of copper tracks and copper soldering pads causing a lot of additional layout based parasitic components. As a consequence, the design of such an implementation is very unstable. This additionally is based on the fact, that even the electrical parameters of the printed circuit board material are not well defined and the material itself has some production spread. Well defined printed circuit board material however, is extreme expensive and does not reduce the number of parasitic effects significantly.

An object of the invention is therefore to provide in particular with regard to the above discussed state of the art a new and improved approach for providing an increased reconfiguration flexibility and even a tuning and/or matching flexibility for high frequency or radio frequency signal transmission systems and/or applications by simultaneously reducing undesirable parasitic influences.

The inventive solution is achieved by a device comprising the features of claim 1.

Advantages and/or preferred embodiments or refinements are the subject matter of the respective dependent claims.

Accordingly, the invention proposes a device for high frequency or radio-frequency tuning and/or matching incorporating within one IC-package at least two capacitors and two inductors, at least one signal path connected to at least one input port and one output port and at least one controllable switching means for individually connecting and disconnecting at least one of the capacitors and/or at least one of the inductors into the signal path or from the signal path.

One of the main advantages achieved thereby is, that due to the use of switching means for individually connecting and disconnecting, the inventive device is providing a complex re-configurable functionality implemented within one IC-package and hence, is able to cover a variety of tuning and matching tasks based on the respectively two capacitors and inductors, too. For example, based on the configured internal structure of the IC-device, the capacitors and/or inductors can be connected into the signal path in series and/or in parallel, can form a serial or parallel resonance circuit and/or the components can be interconnected to a low pass and/or high pass structure for matching purposes. Additionally, by the incorporation of the inventive tuning and matching device into an rf-system sensitive rf-parameters may easily be tuned for optimization purposes, instead of individually designing and optimizing a plurality of matching circuits. This enables, in particular with regard to the manufacture, a significant reduction of development costs and the possibility of compensating tolerances. Moreover, the redesign of critical circuits, for example due to a replacement of certain components usually resulting in time and cost consuming modifications of the circuitry layout, can often be avoided.

Preferably, by using controllable switching means with an actuator and a contact element to close or open the switching means for the individually connecting and disconnecting it can be easily ensured, that the control signal for controlling the switching means can be isolated from the high frequency signal path.

Moreover, since two ports are sufficient for the input and output of the signal path, problems for implementing the inventive device within a further PCB-layout are significantly reduced, too. Additionally, based on the specific adaptation functionality of connecting and disconnecting the components into or from the signal path, each of the port can be used as input and output port, respectively, the flexibility of providing a plurality of different signal path circuits and thus radio functions is further enhanced.

In addition, due to the integration of all these components into one IC-package the dimensions are extremely small with regard to the high frequencies to be tuned and/or matched and hence high frequency signal based parasitic effects caused by large transmission lines are significantly reduced.

According to a preferred refinement, in particular for simplifying the integration within one IC-package it is proposed to fabricate the inventive device by using a so called Micro-Electro-Mechanical-Systems (MEMS) technology.

By using such MEMS technology all internal parasitics are well defined and in comparison with the state of the art of a general PCB based solution, a production spread usually is avoided. The invention proposes further to produce tunable devices and/or the switches as three-dimensional mechanical structures, in particular by employing a bulk micro machining and/or a surface micro machining technology.

Based thereon the actuating mechanisms means are advantageously realized by using MEMS actuators. Preferably, the device additionally comprises at least one MEMS-based tunable capacitor and/or at least one MEMS-based tunable inductor so that the overall capacity and/or inductance tuning range can be further increased by simultaneously reducing the individual scale spacing steps there between.

According to a preferred embodiment the signal path has at least three high frequency ports which can be individually used as inputs or as outputs to further increase the flexibility of covering tuning and/or matching tasks.

For the praxis, it is suggested, to provide a separate control path for each tunable device and/or at least one control bus for controlling the plurality of switches.

Preferably, the at least one control bus for the plurality of MEMS switches is based on a sufficient number of bits for controlling each of the switches individually, wherein the at least one control bus is connectable to a EPROM or EEPROM, so that application specific and/or desired operating conditions of the inventive device can be retrievable stored.

In addition, the tuning paths for controlling the tunable devices are practically adapted to be controllable via an analogue voltage or via a digital to analogue converter.

According to preferred embodiments the actuating mechanisms means respectively comprises a mechanism based on an electrostatic, piezoelectric, thermal, magnetic or bimetallic actuator functionality.

The inductors are preferably based on a spiral hollow inductor and a tunable capacitor may be achieved by varying the effective area of the capacitor by changing the degree of engagement of fingers of comblike structures or by changing the distance between at least two plates.

The invention proposes further an apparatus comprising at least two of the above discussed inventive devices for building up in a very easy manner, a symmetric low pass and/or high pass filter/matching circuit.

As a consequence, by preferably using the technique of Micro-Electro-Mechanical-Systems for the integration of capacitors, inductors, varactors, tunable inductors and high frequency-switches into one IC-package, a versatile electrical device for high-frequency tuning and matching purposes is provided, with the advantages of a very high isolation between the controlling paths and high-frequency paths, a low noise of tunable capacitors and of the possibility to integrate tunable inductors. Hence, low tolerance components with well defined internal parasitics are achieved, wherein the complete inventive configuration is universal in terms of reconfiguration or switching and optimization or tuning/matching and can be used in re-configurable systems of several application areas using a receive/transmit chain.

Subsequently, the invention is exemplary described in more detail based on a preferred embodiment and with regard to the appended drawing, in which:

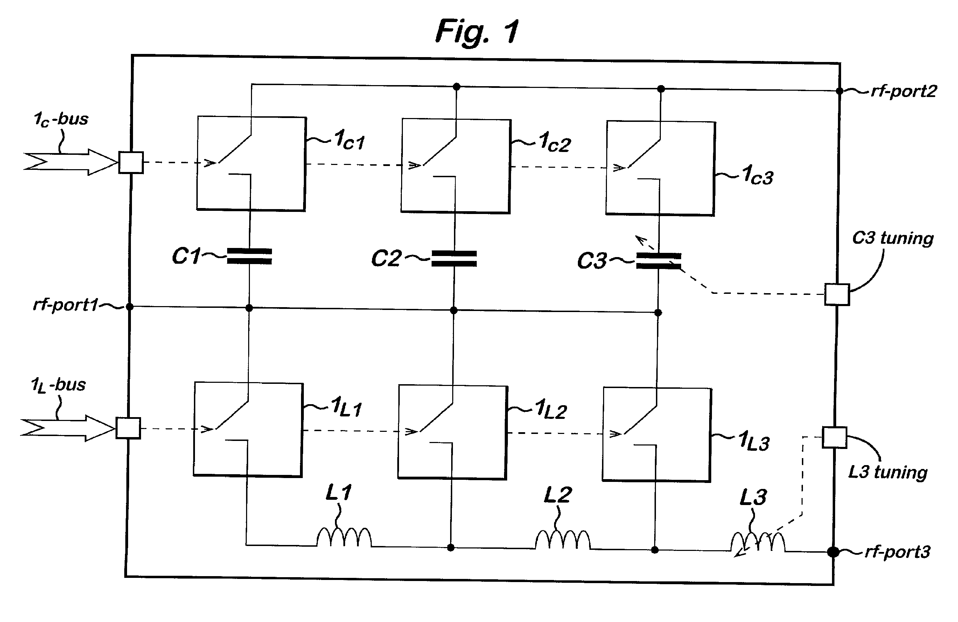

- Fig. 1: is schematically depicting a preferred inventive embodiment of a universal tuning and matching device.

Regarding FIG. 1, a preferred but exemplar embodiment of the universal tuning and matching device according to the invention incorporates the integration of six high-frequency switches 1_{C1}, 1_{C2}, 1_{C3}, 1_{L1}, 1_{L2} and 1_{L3}, of two fixed capacitors C₁ and C₂, one tunable capacitor called varactor C₃, two fixed inductors L₁ and L₂ and one tunable inductor, called variometer L₃ into one IC-device or package fabricated on the basis of the so called MEMS (Micro-Electro-Mechanical-Systems) technology. As can be seen from FIG. 1 the exemplar inventive tuning and matching device incorporates a signal path provided with three signal ports rf-portl, rf-port2 and rf-port3 each of which preferably at an outer IC-package surface for the interconnecting with a further component and individually usable as an input or an output for the signal path, respectively.

Each of the switches 1_{C1}, 1_{C2}, 1_{C3}, 1_{L1}, 1_{L2} and 1_{L3} is controllable based on an actuator part causing a contact part of the switch to close or open the switch, wherein the drive of the actuator part is de-coupled from the signal path, as described below.

For example, regarding the signal path branch between the signal ports rf-port1 and the output port rf-port2 the capacitors C₁, C₂ and C₃ are arranged such that each thereof can be selectively connected within that branch of the signal path in a parallel manner by means of the respective associated switch 1_{C1}, 1_{C2} or 1_{C3} . Regarding the signal branch between the signal ports rf-portl and rf-port3, the inductors L₁, L₂ and L₃ are arranged such that each of these inductors can be selectively connected with that branch of signal path in a serial manner by means of the respective associated switch 1_{L1}, 1_{L2} or 1_{L3}. Regarding the signal path connection between the port rf-port2 and the port rf-port3, the tunable capacitor C₃ and the tunable inductor L₃ for example, may be connected into the signal path to form a series resonance circuit by means of the respective associated switch 1_{C3} and 1_{L3}, respectively.

Thus, even if the number of three switches 1_{C1}, 1_{C2} and 1_{C3} or 1_{L1}, 1_{L2} and 1_{L3} in each branch is just an example, with the internal structure of the inventive tuning and matching device it is possible to cover a variety of tuning and matching tasks, such as connecting capacitors and/or inductors in series and/or capacitors and/or inductors in parallel. Furthermore serial resonance circuits and/or parallel resonance circuits can be created individually in series and/or in parallel respectively forming a low impedance bandpass or bandstop and/or a high impedance bandstop or bandpass. Moreover, low pass structures and/or high pass structures for matching high to low or low to high impedance can be realized simply by reconfiguration, i.e. by actuating the respective associated switches 1_{C1}, 1_{C2}, 1_{C3}, 1_{L1}, 1_{L2} and/or 1_{L3} to go in an on or off condition. In addition, by connecting two of the devices according to Fig. 1 together, a symmetrical low pass or high pass filter/matching circuit can be built up. Even with regard to the manufacture, inventive tuning and matching devices may be incorporated into a rf-system to easily tune sensitive rf-parameters for optimization purposes, instead of individually designing and optimizing a plurality of matching circuits of the rf-system.

Furthermore, as can be seen from FIG. 1 the switches 1_{C1}, 1_{C2} and 1_{C3} responsible for connecting or disconnecting the respective capacitors C₁, C₂ and C₃ into the signal path or from the signal path are preferably controlled by a bus, identified by the reference sign 1_{C}-bus, for example a 3-bit bus for controlling each of the switches 1_{C1}, 1_{C2} and 1_{C3} individually.

Correspondingly, the switches 1_{L1}, 1_{L2} and 1_{L3} responsible for the connecting or disconnecting of the inductors L₁, L₂ and L₃ into the signal path or from the signal path are controlled by a separate 3-bit bus, 1_{L}-bus for controlling each of these switches L₁, L₂ and L₃ individually. Furthermore, each of the control busses 1_{C}-bus and 1_{L}-bus are preferably connected to an EPROM or even an EEPROM for retrievable storing different operating conditions. Thus if an application specific operating condition is desired the correspondingly stored condition can be activated in a simple manner by use of such (E)EPROM.

Furthermore the tunable capacitor C₃ is connected to a separate tuning port C3-tuning and the tunable inductor L₃ is connected to a separate tuning port L-tuning each of which can be controlled, especially via an analogue voltage or via a digital to analogue converter.

Thus by using not only fixed capacitors C₁, C₂ and fixed inductors L₁ and L₂ but in addition at least one tunable capacitor C₃ or varactor and one tunable inductor L₃ or variometer the scaling step sizes between the lowest and the highest values of the range of values can be reduced for accurate and/or precise tuning and/or matching optimization purposes, preferably covering the entire range by providing overlapping regions.

The entire IC-package or device is preferably produced by providing 3-dimensional mechanical structures for example based on a bulk micromachining technology and/or a surface micromachining technology.

In particular, in bulk micromachining these structures, in particular the tunable components C3 and L3 and the switches 1_{C1}, 1_{C2}, 1_{C3}, 1_{L1}, 1_{L2} and 1_{L3} may be sculpted within the confines of a wafer by exploiting the anisotropic etching rates of different atomic crystallographic plans in the wafer. On the other hand side, the structures may be formed by the process of fusion bonding, which entails building up a structure by atomically bonding various wafers.

According to the surface micromachining based MEMS technology the 3-dimensional mechanical structures may be built up by the orchestrated addition and removal of a sequence of thin film layers to or from a wafer surface.

As a further alternative the mechanical structures may be fabricated by using thick photoresists which are exposed to X-rays to produce molds that are subsequently used to form high-aspect ratio electroplated 3-dimensional structures.

In this regard, i.e. based on a Micro-Electro-Mechanical-Systems-technology, the switches 1_{C1} to 1_{L3} can be designed with a very low insertion loss, a high linearity and a high isolation, in particular with regard to the control signal transmitted by the busses 1_{C}-bus and 1_{L}-bus to the switch actuators, that is essentially absolutely de-coupled or isolated from the switch contacts and hence, from the high-frequency or radio-frequency signal path.

The actuators of the switches 1_{C1} to 1_{L3} may be based on a plurality of structures including a cantilever, a membrane, a shape-memory alloy and/or a multi-pole/multi-throw.

As a preferred actuation mechanism an electrostatic mechanism is used, i.e. a positive and/or negative charge applied by a control voltage by the busses 1_{C}-bus and/or 1_{L}-bus between certain structural members of the MEMS switches elicit coulomb forces which produce motion. As an alternative, the actuation mechanism may be based on a piezoelectric effect, i.e. the control voltage is applied by the busses 1_{C}-bus and/or 1_{L}-bus on a certain structure of a respective MEMS switch for inducing a field, which changes the physical dimensions of the structure to communicate motion. As further exemplar alternatives, a control current can be forced by the busses 1_{C}-bus and/or 1_{L}-bus through a certain element of a respective MEMS switch causing it to heat up and expand with the physical dimensional change used to communicate motion, a control signal applied by the busses 1_{C}-bus and/or 1_{L}-bus can induce a magnetic force producing motion.

Hence, a number of actuation mechanisms may be used for high frequency MEMS device applications. However, an electrostatic based actuation is one of the most preferred actuation mechanisms and surface micromachining which is preferably used for producing electrostatically-based actuators is compatible with integrated circuit fabrication processes.

Furthermore, the MEMS switches 1_{C1} to 1_{L3} can be used with resistive or metal to metal contact areas and/or with capacitively-coupled switching areas in which the contact is made via an insulating dielectric layer.

The inductors L₁, L₂ and/or L₃ can be based for example on spiral hollow inductors, wherein the tunable inductor or variometer L₃ comprises at least two coupled inductors with at least one of which pivoted for varying the inductance coupling. The capacitors C₁, C₂ and C₃ can be based for example on at least two spaced plates or on a comblike structure, wherein the tunable capacitor C₃ or varactor then can be based for example, on a variation of the effective area of the capacitor by changing the distance between the plates or the degree of engagement of fingers of the comblike structure, controlled by a tuning voltage.

By using the MEMS-technology, substantially all internal parasitics of the MEMS structures are well defined without no production spread in substantial, so that low tolerance components are achieved such that the complete configuration is universal in terms of reconfiguration and optimization and can be used in re-configurable and/or tunable systems and/or in several areas of a receive/transmit chain, in particular within applications where the reconfiguration and/or tuning requirements are not critical with regard to time, since the mechanical structures or components may introduce a kind of mechanical inertia.

Moreover based on the preferred embodiments using the MEMS technology the varactor tuning voltage with the tuning port "C3-tuning" as well as the inductor tuning voltage with the tuning port "L3-tuning" are isolated from the high frequency-signal path. Hence in particular the tunable capacitor has a low noise and the integration of variometers, i.e. tunable inductors is possible by using the MEMS technology.

However, the control paths 1_{C}-bus and 1_{L}-bus for controlling the switches and the control paths for controlling the tunable components may be alternatively combined into one control bus.

It is mentioned, that even the invention is described with regard to respective two fixed and one tunable capacitors, two fixed and one tunable inductors and six actuator switches, the invention also comprises embodiments incorporating a different number of components, since the structure of the inventive device can also be scaled in terms of more fixed and variable devices. Even the number of three switches in each branch, i.e. between the signal ports rf-port1 and the output port rf-port2 or between the signal ports rf-portl and the output port rf-port3, is just an example.

## Claims

1. Device for high-frequency and/or radio-frequency tuning and/or matching comprising within one IC-package at least two capacitors (C₁, C₂, C₃) and at least two inductors (L₁, L₂, L₃), at least one signal path providing at least one input and one output port (rf-port1, rf-port2, rf-port3) and at least one controllable switching means (1_{C1}, 1_{C2}, 1_{C3}, 1_{L1}, 1_{L2}, 1_{L3}) for individually connecting and disconnecting at least one of the capacitors (C₁, C₂, C₃) and/or at least one of the inductors (L₁, L₂, L₃) into the signal path or from the signal path.

2. Device of claim 1, comprising at least one control signal path isolated from the rf-signal path into which the at least one capacitor and/or inductor is connectable for controlling the switching means (1_{C1}, 1_{c2}, 1_{C3}, 1_{L1}, 1_{L2}, 1_{L3}) and/or for controlling at least one tunable component (C3, L3) incorporated in the device.

3. Device of claim 2, comprising a separate control path for each tunable component (C₃, L₃) and/or at least one control bus for controlling a plurality of switching means (1_{C1}, 1_{C2}, 1_{C3}, 1_{L1}, 1_{L2}, 1_{L3}).

4. Device of claim 3, wherein the at least one control bus for the plurality of switching means (1_{C1}, 1_{C2}, 1_{C3}, 1_{L1}, 1_{L2}, 1_{L3}) is based on a sufficient number of bits for controlling each of the of switching means (1_{C1}, 1_{C2}, 1_{c3}, 1_{L1}, 1_{L2}, 1_{L3}) individually and/or wherein the at least one control bus is connectable to an EPROM or EEPROM and/or wherein the at least one path for controlling the tunable components (C₃, L₃) is adapted to be controllable via an analogue voltage or via a digital to analogue converter.

5. Device of any of the preceding claims, wherein the switching means (1_{C1}, 1_{C2}, 1_{C3}, 1_{L1}, 1_{L2}, 1_{L3}) respectively comprises an actuator for driving a contact element of the switching means to close or open the switching means.

6. Device of any of the preceding claims, wherein the switching means (1_{C1}, 1_{C2}, 1_{C3}, 1_{L1}, 1_{L2}, 1_{L3}) respectively comprises an actuating mechanism based on an electrostatic, piezoelectric, thermal, magnetic or bimetallic actuator functionality and/or at least one of said at least two inductors (L₁, L₂, L₃) is based on a spiral hollow inductor and/or wherein a tunable capacitor (C₃) has an effective area which can be varied by changing the distance between at least two plates or the degree of engagement of fingers of a comblike structure.

7. Device of any of the preceding claims, wherein the controllable switching means is produced as MEMS rf-switch means (1_{C1}, 1_{C2}, 1_{C3}, 1_{L1}, 1_{L2}, 1_{L3}) and the device comprises at least one MEMS varactor (C₃) and at least one MEMS variometer (L₃) .

8. Device of any of the preceding claims, produced by using a Micro-Electro-Mechanical-Systems (MEMS) technology, in particular produced by employing a bulk micromachining and/or a surface micromachining technology.

9. Device of any of the preceding claims, comprising six controllable rf-switches (1_{C1}, 1_{C2}, 1_{C3}, 1_{L1}, 1_{L2}, 1_{L3}), two fixed capacitors (C₁, C₂), two fixed inductors (L₁, L₂), one tunable capacitor (C₃) and one tunable inductor (L₃) and a rf-signal path providing three rf-ports (rf-portl, rf-port2, rf-port3) at an outer IC-package surface for the interconnecting with a further component.

10. Apparatus comprising at least two devices according to any of the preceding claims, wherein said two devices are electrically connected with each other.
